Europäisches Patentamt

European Patent Office

Office européen des brevets

(11) Publication number: **0 410 392 A1**

# EUROPEAN PATENT APPLICATION

(21) Application number: 90114188.7

(22) Date of filing: 24.07.90

(51) Int. Cl.5: **H01L 29/73**, H01L 29/743, H01L 29/06

(30) Priority: 25.07.89 JP 193013/89

(43) Date of publication of application:
30.01.91 Bulletin 91/05

(84) Designated Contracting States:
DE FR GB

(71) Applicant: NEC CORPORATION
7-1, Shiba 5-chome Minato-ku
Tokyo 108-01(JP)

(72) Inventor: Mukai, Kanzi
c/o NEC Corporation, 7-1 Shiba 5-chome
Minato-ku, Tokyo(JP)

(74) Representative: Glawe, Delfs, Moll & Partner
Patentanwältelte
Postfach 26 01 62
D-8000 München 26(DE)

(54) Semiconductor device having a high breakdown voltage.

(57) In a semiconductor device which includes a high breakdown voltage lateral pnp bipolar transistor formed in a dielectrically isolated single crystal silicon island (101c), a channel stopper electrode of a second level wiring (115) is formed above the gap portion between a collector diffusion region (106) and an emitter diffusion region (107), and is connected to a base diffusion region (108). With this arrangement, generation of a parasitic channel in the gap portion can be prevented so that it it possible to avoid an increase in the leakage current even when this semiconductor is mounted on a resin sealed package.

EP 0 410 392 A1

# SEMICONDUCTOR DEVICE HAVING A HIGH BREAKDOWN VOLTAGE

## BACKGROUND OF THE INVENTION

### Field of the Invention

The present invention relates to a semiconductor device, and more particularly to a semiconductor device which includes a lateral type element having a high breakdown voltage.

### Description of the Prior Art

In old days, high breakdown voltage semiconductor devices used to attain a high breakdown voltage of the order of 300 V by means of a deep junction of the order of 30 $\mu$m. Along with the advances in the semiconductor technology, however, the junction of the high breakdown voltage semiconductor devices has become a shallow one of the order of 2 - 5 $\mu$m. A high breakdown voltage semiconductor device having such a shallow junction will now be described using a high breakdown voltage lateral pnp bipolar transistor as an example. A $p^+$ type collector diffusion region and a $p^+$ type emitter diffusion region are formed on a main surface of an $n^-$ type single crystal silicon substrate. An $n^+$ type base contact diffusion region is formed on the main surface in a portion other than the gap portion between the $p^+$ type collector diffusion region and the $p^+$ type emitter diffusion region. Predetermined openings are provided in a silicon dioxide film formed on the single crystal silicon substrate, and a collector electrode, an emitter electrode and a base electrode are formed to be connected to the collector diffusion region, the emitter diffusion region and the base contact diffusion region, respectively, via the above-mentioned openings. Now, because of the low impurity concentration of the single crystal silicon substrate a parasitic channel tends to be created in the gap portion between the collector diffusion region and the emitter diffusion region. In order to prevent this from happening the collector electrode and the emitter electrode are given the field plate structure. Namely, the collector electrode is extended in the direction of the emitter diffusion region and the emitter electrode is extended in the direction of the collector diffusion region. However, when a bias temperature (BT) test is given to a semiconductor device with the aforementioned structure mounted on a resin sealed package, there is normally observed an increase in the leakage current. The reason for this is the presence of impurity ions in the sealing resin. In the case a lateral pnp bipolar transistor an increase in the leakage current is noticed especially when there exist negative ions in the sealing resin. In other words, the provision of the field plate structure does not suffice for the prevention of the increase in the leakage current.

A similar problem arises also in a high breakdown voltage lateral pnpn thyristor mounted on a resin sealed package.

## BRIEF DESCRIPTION OF THE INVENTION

### Objects of the Invention

It is an object of the present invention to provide a semiconductor device with high breakdown voltage.

It is an object of the present invention to provide a high breakdown voltage semiconductor device having a structure which can reduce the leakage current caused by the parasitic channel effect.

It is an object of the present invention to provide a high breakdown voltage semiconductor device mountable on a resin sealed package.

It is an object of the present invention to provide a high breakdown voltage bipolar transistor having lateral pnp structure.

It is an object of the present invention to provide a high breakdown voltage bipolar transistor of lateral pnp structure having a structure that can reduce the leakage current caused by the parasitic channel effect.

It is an object of the present invention to provide a high breakdown voltage bipolar transistor of lateral pnp structure mountable on a resin sealed package.

It is an object of the present invention to provide a high breakdown voltage thyristor having a lateral pnpn structure.

It is an object of the present invention to provide a high breakdown voltage thyristor of lateral pnpn configuration having a structure which enables to reduce the leakage current caused by the parasitic channel effect.

It is an object of the present invention to provide a high breakdown voltage thyristor of lateral pnpn configuration which is mountable on a resin sealed package.

### Summary of the Invention

In accordance with a first aspect of the semiconductor device of the present invention, within a single crystal silicon island having one conductivity type formed on a main surface of a semiconductor substrate dielectrically separated by a dielectric film, there are formed a first diffusion region and a second diffusion region of the opposite conductivity type, and a third diffusion region of the one conductivity type is formed within the single crystal silicon island at a position other than the gap portion between the first diffusion region and the second diffusion region. A first, a second and a third electrodes formed by a first level wiring layer are connected to the first, the second and the third diffusion regions, respectively. Between the first electrode and the second electrode there is formed a channel stopper electrode that is formed by a second level wiring layer. The channel stopper electrode is connected to the third electrode.

It is preferable that the end caps of the channel stopper electrode extend beyond the limit of the single crystal silicon island.

It is preferable that the oppositely situated sides of the first electrode and the second electrode are covered with the channel stopper electrode.

It is preferable that the dielectric film is a thermally oxidized silicon dioxide.

It is preferably that the package for the semiconductor device is a resin sealed package.

In accordance with a second aspect of the semiconductor device of the present invention, within a single crystal silicon island having one conductivity type formed on a main surface of a semiconductor substrate being isolated dielectrically by a dielectric film, there are formed a first diffusion region and a second diffusion region of the opposite conductivity type, a third diffusion region of the one conductivity type is formed within the single crystal silicon island at a position other than the gap portion between the first diffusion region and the second diffusion region, and a fourth diffusion region of the one conductivity type is formed in the first diffusion region. To the first, second, third and fourth diffusion regions there are connected a fourth, a second, a third and a first electrodes, respectively, formed by first level wiring layers. The first electrode is formed between the fourth electrode and the second electrode. In addition, a channel stopper electrode formed by a second level wiring layer is provided between the first electrode and the second electrode. Further, the channel stopper electrode is connected to the third electrode.

It preferable that the end caps of the channel stopper electrode extend to the outside of the single crystal silicon island.

It is preferable that the oppositely situated sides of the first and the second electrode are covered by the channel stopper electrode.

It is preferable that the dielectric film is a thermally oxidized silicon dioxide film.

It is preferable that the package for the semiconductor device is a resin sealed package.

By the provision of the above-mentioned channel stopper electrode it becomes possible to reduce the leakage current caused by the parasitic channel effect.

## BRIEF DESCRIPTION OF THE DRAWINGS

The above-mentioned and other objects, features and advantages of this invention will become more apparent by reference to the following detailed description of the invention taken in conjunction with the accompanying drawings, wherein:

FIG. 1A is a plan view showing the semiconductor device in accordance with a first embodiment of the present invention;

FIG. 1B is a sectional view of the first embodiment taken along the line AA$'$ in FIG. 1A;

FIG. 2 is a schematic sectional view when the semiconductor device of the first embodiment of the present invention is mounted on a package;

FIG. 3A to Fig. 3I are sectional views arranged in the processing order for explaining the method of fabricating the semiconductor device of the first embodiment of the present invention;

FIG. 4 is a schematic diagram showing an experiment for comparing the effect of the first embodiment of the present invention;

FIG. 5 is a graph showing the result of the experiment depicted in FIG. 4;

FIG. 6 is a schematic diagram showing an experiment for explaining the effect of the first embodiment of the present invention;

FIG. 7 is a graph showing the result of the experiment depicted in FIG. 6;

FIG. 8A is a plan view for explaining a second embodiment of the present invention; and

FIG. 8B is a sectional view of the second embodiment taken along the line AA$'$ in FIG. 8A.

## DETAILED DESCRIPTION OF THE PREFERRED EMBODIMENTS

Referring to the drawings, the present invention will be described in what follows.

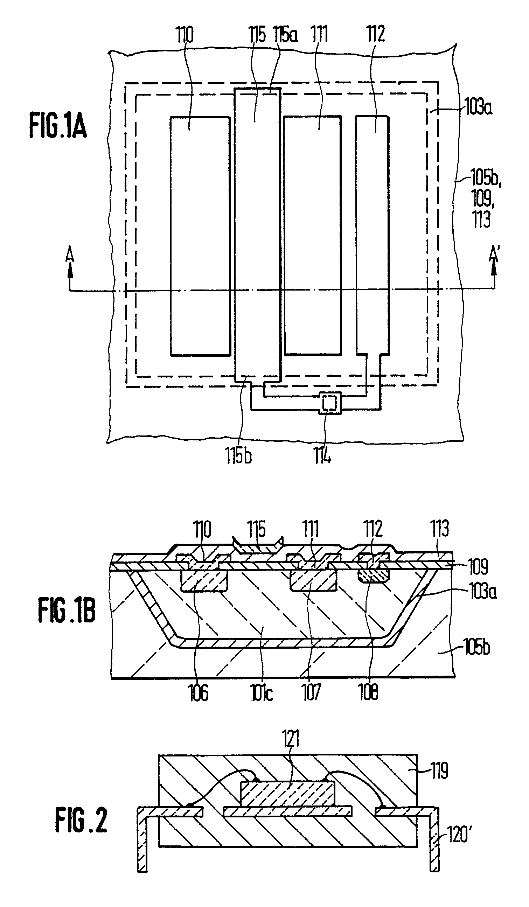

FIGs. 1A and 1B are a plan view and a sectional view, respectively, for describing the first embodiment of the present invention. The present embodiment relates to a high breakdown voltage leteral pnp bipolar transistor.

On a main surface of a polycrystalline silicon 105b which is a semiconductor base, an $n^-$ type single crystal silicon island 101c is formed dielectrically isolated by a thermally oxidized silicon dioxide film 103a which is a dielectric film, making up a semiconductor substrate. Within the single crystal silicon island 101c, there are formed a $p^+$ type collector diffusion region 106 which is a first diffusion region, a $p^+$ type emitter diffusion region 107 which is a second diffusion region and an $n^+$ type base contact diffusion region 108 which is a third diffusion region. The base contact diffusion region 108 is formed in a portion which is other than the gap portion between the collector diffusion region 106 and the emitter diffusion region 107. A collector electrode 110, an emitter electrode 111 and a base electrode 112 consisting of a first level wiring layer made of aluminum, for example, are connected to the collector diffusion region 106, the emitter diffusion region 107 and the base contact diffusion region 108, respectively, via the respective openings provided at predetermined locations in a silicon dioxide film 109 on the surface of the semiconductor substrate. A channel stopper electrode 115 consisting of a second level wiring layer made of an aluminum film, for example, is formed over the gap portion between the collector electrode 110 and the emitter electrode 111 via an interlayer insulating film 113 consisting, for example, of a silicon dioxide film or a PSG film or a BPSG film or a laminated film of these films. The channel stopper electrode 115 is connected to the base electrode 112 via a through hole 114 opened in the interlayer insulating film 113.

FIG. 2 is a sectional view showing the condition in which a semiconductor chip 121 that includes a high breakdown voltage lateral pnp bipolar transistor shown in FIGs. 1A and 1B is mounted on a lead from 120, the electrodes 110, 111 and 112 are bonded to the lead frame 120 by thin gold wires, and sealed with a sealing resin 119.

Next, referring to the sectional views, FIGS. 3A to 3I, arranged in the order of processings, the method of fabricating a high breakdown voltage lateral pnp bipolar transistor of the present invention will be described.

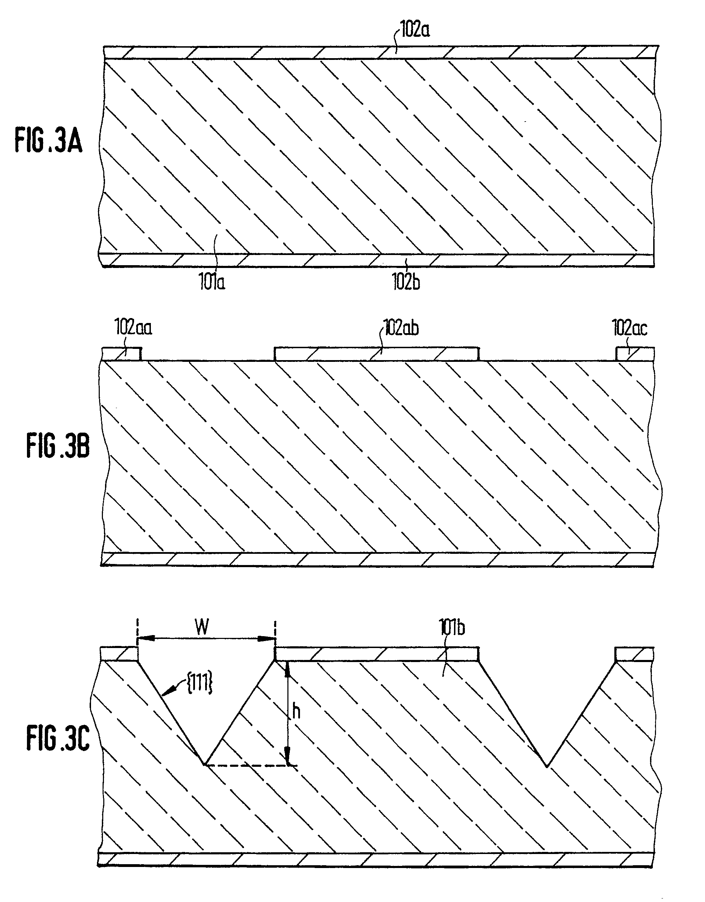

First, thermally oxidized silicon dioxide films 102a and 102b with thickness of about 1 $\mu$m are formed on the front surface and the rear surface, respectively, of an $n^-$ type single crystal silicon substrate 101a with thickness of about 500 $\mu$m, the crystal orientation of (100) and specific resistance $\rho$ of about 20 $\Omega \cdot$cm [FIG. 3A], then silicon dioxide films 102aa, 102ab and 102ac are formed by selectively etching the front surface silicon dioxide film 102a by the ordinary photolithography [FIG. 3B] and a semiconductor silicon substrate 101b having V-shaped grooves consisting of the {111} surfaces are formed by means of an anisotropic wet etching of mesa etching [FIG. 3C]. In the present embodiment, the depth h of the V-shaped groove is set to 63 $\mu$m and its width W is set to 90 $\mu$m.

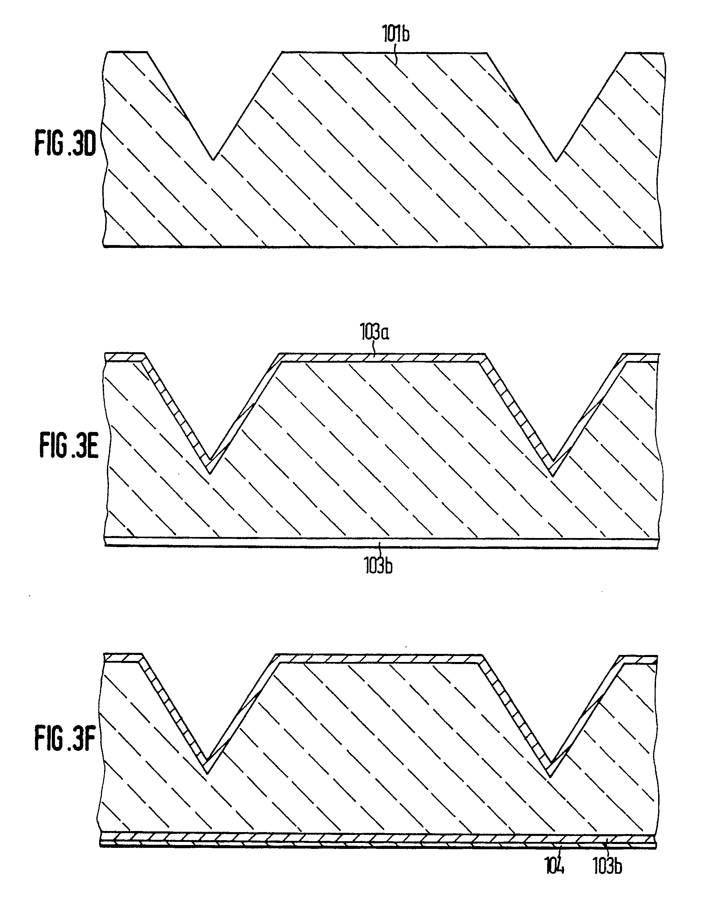

Next, the silicon dioxide films 102aa, 102ab, 102ac and 102b are removed by a wet etching using hydrofluoric acid [FIG. 3D], silicon dioxide films 103a and 103b with thickness of about 2.5 $\mu$m are formed on the front surface and the rear surface of the semiconductor silicon substrate 101 again by a thermal oxidation [FIG. 3E], a silicon nitride film 104 of thickness of about 200 nm is formed on the rear surface of the substrate 101b [FIG. 3F] and a polycrystalline silicon film 105a of thickness of about 650 $\mu$m is deposited on the front surface of the substrate 101b [FIG. 3G].

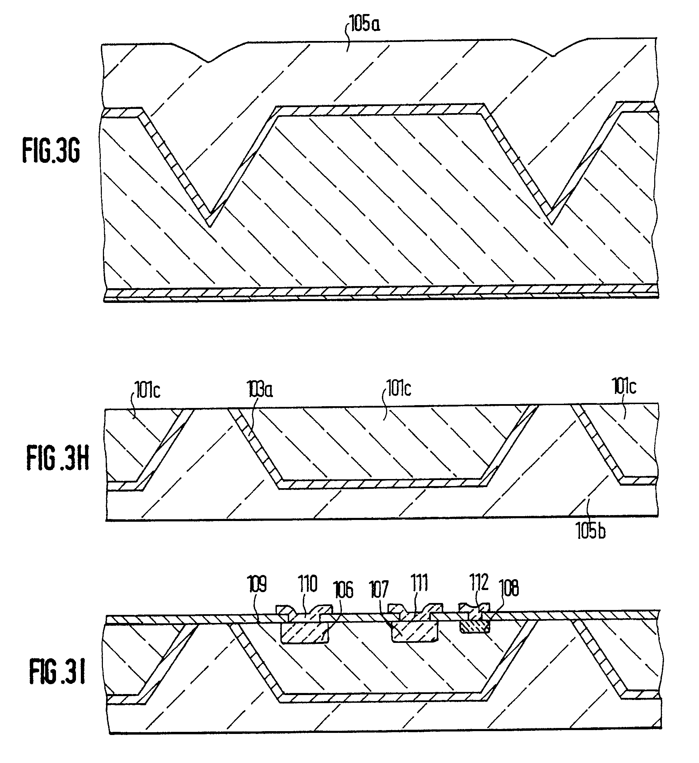

Next, a polycrystalline silicon 105b is formed first by grinding the polycrystalline silicon film 105a by about 200 $\mu$m, then the silicon nitride film 104 and the silicon dioxide film 103b are removed by etching, and a polycrystalline silicon island 101c is formed by grinding the single crystal silicon substrate 101b by about 450 $\mu$m [FIG. 3H]. In this stage, the thickness of the semiconductor substrate becomes about 500 $\mu$m. The grindings employed in the above processes are mechanical grindings in a solution of hydrofluoric acid.

Following the above, formation of a thermally oxidized silicon dioxide film 109, formation of a $p^+$ type collector diffusion region 106, a $p^+$ type emitter diffusion region 107 and an $n^+$ type base contact diffusion region 108 within the single crystal silicon island 101c and formation of a collector electrode 110, an emitter electrode 111 and a base electrode 112 are performed by means of the ordinary diffusion technology, photolithography technology, film formation technology, and the like [FIG. 3I]. By further carrying out deposition of an interlayer insulating film, opening of a through hole and formation of a channel stopper electrode there is obtained a high breakdown voltage lateral pnp bipolar transistor as shown in FIGs. 1A and 1B.

The silicon dioxide film 103a obtained by a thermal oxidation functions as a dielectric film for dielectric isolation. The reasons for employing the silicon dioxide film 103a as the dielectric film are the following two points. First point is that it does not contain impurities. Second point is that the silicon film 103a has an excellent adhesion with the polycrystalline silicon films 105a and 105b, and that there occurs no separation between them even when the system is subjected to a treatment at high temperatures.

The reasons for forming the silicon nitride film 104 are to prevent the warping of the semiconductor substrate against the high temperature treatment for over a long time during the growth of the polycrystalline silicon film 105a and against the heating at the time of grinding the polycrystalline silicon film 105a, and to prevent the single crystal silicon substrate 101 chemically as well as mechanically at the time of grinding of the polycrystalline silicon film 105a.

It should be pointed out here that the front surface and the rear surface in FIGs. 3H and 3I are opposite to the front surface and the rear surface in FIGs. 3A to 3G.

Next, the effect of the present embodiment will be described.

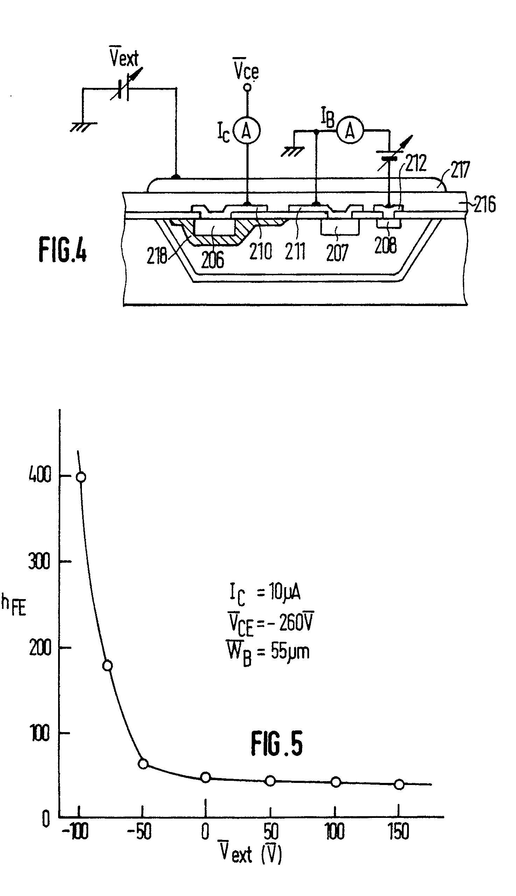

First, a sample with the field plate structure and the dielectric isolation structure is manufactured to carry out a simulation experiment as shown in FIG. 4 for the purpose of comparison with the present embodiment.

In this sample, a $p^+$ type collector diffusion region 206, a $p^+$ type emitter diffusion region 207 and an $n^+$ type base contact diffusion region 208 are formed within a single crystal silicon island, the base contact diffusion region 208 being formed in a portion other than the gap portion between the collector diffusion region 206 and the emitter diffusion region 207, a collector electrode 210, an emitter electrode 211 and a base electrode 212 are connected to the collector diffusion region 206, the emitter diffusion region 207 and the base contact diffusion region 208, respectively, via the corresponding openings provided at predetermined locations in the silicon dioxide film formed on the surface, a surface protective film 216 is formed on top of it and a coated electrode 217 is formed on the surface of the surface protective film 216.

A voltage $V_{ext}$ is applied to the coated electrode 217, a voltage $V_{CE}$ is applied to the collector electrode 210 and the emitter electrode 211 is grounded. For the value of the base width $W_B$, namely, the width of the gap portion between the collector diffusion region 206 and the emitter diffusion region 207, of 55 $\mu$m and the value of $V_{CE}$ of -260 V, base current $I_B$ is measured by varying the voltage applied to the base electrode 212 so as to have a collector current $I_C$ of 10 $\mu$A for the changes in $V_{ext}$, in order to compute $h_{FE}$.

The purpose of the simulation experiment is to create a condition which is similar to a measurement after a BT test. The electric charge that is induced by the BT test on the interface between the sealing resin and the semiconductor chip is simulated by an electric charge that is induced by the application of the voltage $V_{ext}$.

In accordance with the result of the experiment, the value $h_{FE}$ varies markedly for the negative values of $V_{ext}$ as shown in FIG. 5. The reason for this behavior is considered due to the fact that when $V_{ext}$ is negative, a negative charge is induced in the bottom part of the surface protective film 216, a parasitic channel is generated by this negative charge in the gap portion between the collector diffusion region 206 and the emitter diffusion region 207 which causes a depletion layer 218 to extend even to the gap portion between the collector diffusion region 206 and the emitter diffusion region 207. Because of this, the apparent base width (width of the gap portion between the depletion layer 218 and the emitter diffusion region 207) is reduced. As a result, $h_{FE}$ is increased and the leakage current tends to be generated.

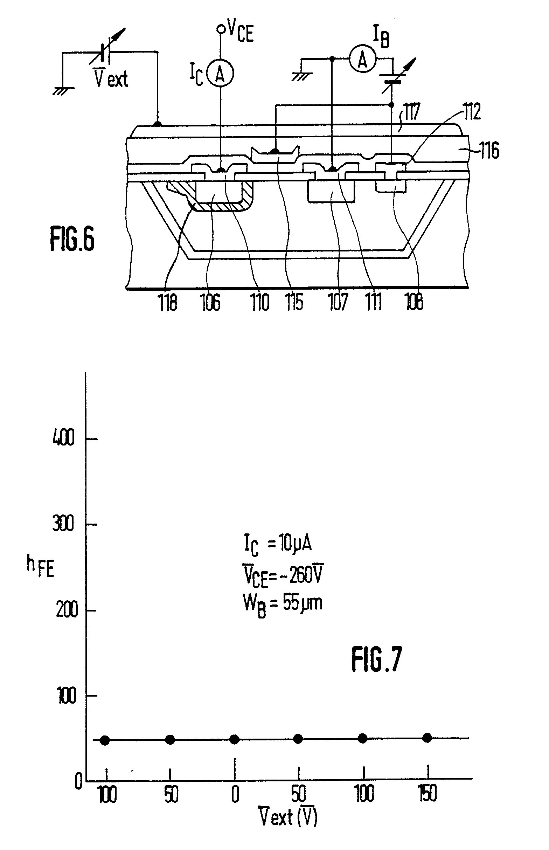

FIG. 6 is a schematic diagram explaining the simulation experiment for showing the effect of the present embodiment.

In the sample used for the experiment, a surface protective film 116 consisting of silicon nitride, for example, is deposited on the surface of the bipolar transistor shown in FIGs. 1A and 1B, and a coated electrode 117 is formed on the surface of the surface protective film 116.

A voltage $V_{ext}$ is applied to the coated electrode 117, a voltage $V_{CE}$ is applied to the collector electrode and the emitter electrode 111 is grounded. For the value of the base width $W_B$, namely, the width of the gap portion between the collector diffusion region 206 and the emitter diffusion region 207, of 55 $\mu$m and the value of $V_{CE}$ of -260 V, base current $I_B$ is measured by varying the voltage applied to the base electrode 112 and the channel stopper electrode 115 so as to have a collector current $I_C$ of 10 $\mu$A for the change in $V_{ext}$, in order to evaluate $h_{FE}$.

The result of the experiment is that the value of $h_{FE}$ is nearly constant for the changes in $V_{ext}$ as shown in FIG. 7. From this result it is estimated that the leakage current will not increase even after a BT test in accordance with the present embodiment. Even in a measurement of $h_{FE}$ after a BT test by actually mounting a bipolar transistor according to the present embodiment on a resin sealed package, there is observed almost no change in $h_{FE}$, and an increase in the leakage current is not observed either.

Based on the result of the simulation experiment in the above, the reason for the nonvariation of $h_{FE}$ after a BT test can be considered as in the following. During a BT test, the channel stopper electrode 115 connected to the base electrode 112 remains at a (negative) potential which is nearly the same as that of the collector electrode 110. Because of this, the negative charge that is induced in the interface between the sealing resin and the semiconductor chip by the BT test is kept away from the vicinity of the channel stopper electrode 115. Consequently, even after the BT test there will not be induced a charge which will generate a parasitic channel in the gap portion between the collector diffusion region 106 and the emitter diffusion region 107, so that the growth of the depletion layer 118 is normal, and there occurs no change in the value of $h_{FE}$.

Further, by extending the end caps 115a and 115b of the channel stopper electrode 115 to the outside of the single crystal silicon island 101c as shown in FIG. 1A, the present embodiment can suppress the generation a parasitic channel that may arise on the outside of the gap portion between the collector diffusion region 106 and the emitter diffusion region 107.

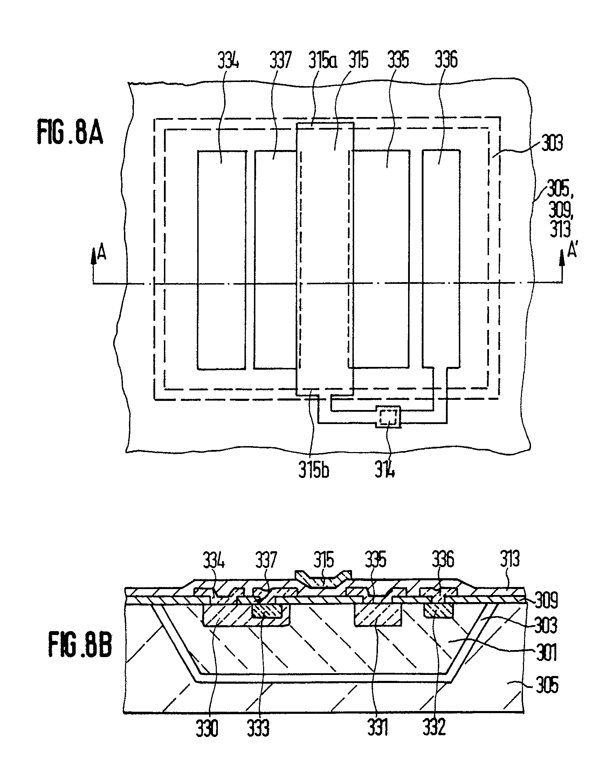

FIGs. 8A and 8B are a plan view and a sectional view for explaining a second embodiment of the present invention. The present embodiment relates to a high breakdown voltage lateral pnpn thyristor.

On a main surface of a polycrystalline silicon 305 which is a semiconductor base, there is formed an $n^-$ type single crystal silicon island 301 dielectrically isolated by a thermally oxidized silicon dioxide film 303 which is dielectric film, constituting a semiconductor substrate. A $p^+$ type cathode gate diffusion region 330 which is a first diffusion region, a $p^+$ type anode diffusion region 331 which is a second diffusion region and an $n^+$ type anode gate contact diffusion region 332 which is a third diffusion region are formed within a single crystal silicon island 301. The base contact diffusion region 332 is formed in a portion other than the gap portion between the cathode gate diffusion region 330 and the anode diffusion region 331. Further, an $n^+$ type cathode diffusion resion 333 which is a fourth diffusion region is formed at a predetermined region within the cathode gate diffusion region 330. A cathode gate electrode 334, an anode electrode 335, an anode gate electrode 336 and a cathode electrode 337 consisting of first level wiring layers made of an aluminum film, for example, are connected to the cathode gate diffusion region 330, the anode diffusion region 331, the anode gate contact diffusion region 332 and the cathode diffusion region 333, respectively, via the corresponding openings provided at predetermined locations in a thermally oxidized silicon dioxide film 309 on the surface of the semiconductor substrate. A channel stopper electrode 315 of a second level wiring layer consisting of an aluminum film, for example, is formed above the gap portion between the cathode electrode 337 and the anode electrode 335 via an interlayer insulating film 317 consisting, for example, of a silicon dioxide film or a PSG film or a BPSG film or a laminated film made of these films just mentioned. The channel stopper electrode 315 is connected to the anode gate electrode 336 via a through hole 314.

From the description in the above, it will be seen that the channel stopper electrode 315 is formed above the gap portion between the collector diffusion region (cathode gate diffusion region 330) and the emitter diffusion region (anode diffusion region 331) of a lateral pnp bipolar transistor formed by the cathode gate diffusion region 330, the single crystal silicon island 301 and the anode diffusion region 331. Namely, as to the diffusion regions the structure of the present embodiment is the same as that of the first embodiment of the present invention.

It should be noted in the present embodiment that the end caps 315a and 315b of the channel stopper electrode are extended to the outside of the single crystal silicon island 301. Moreover, the channel stopper electrode 315 covers a part of the cathode electrode 337 and a part of the anode electrode 335. Consequently, the shielding effect of the present embodiment will be superior to that of the first embodiment of the present invention.

Next, the effect of the present embodiment will be described. A bipolar transistor with a space between the cathode gate diffusion region 330 and the anode diffusion region 331 of 70 $\mu$m is mounted on a resin sealed package, and a BT test is performed under the conditions of 125°C, 20 hours and $V_{AK}$ = 170 V. A measurement of the anode leakage current at $V_{AK}$ = 260 V thereafter produced a value of 1.38 ± 0.72 $\mu$A. On the other hand, a similar BT test was performed for a high breakdown voltage lateral pnpn thyristor that has the dielectric isolation structure and the field plate structure between the cathode electrode and the anode electrode with a separation of 30 $\mu$m between the electrodes, and has a spacing of 70 $\mu$m between the cathode gate region and the anode diffusion region. The anode leakage current following the BT test was found to be 26.5 ± 5.0 $\mu$A.

The mechanism by which the effect of the present embodiment is generated is the same as that of the first embodiment of the present invention.

Although the invention has been described with reference to specific embodiments, this description is not meant to be construed in a limiting sense. Various modifications of the disclosed embodiment, as well as other embodiments of the invention, will become apparent to persons skilled in the act upon reference to the description of the invention. It is therefore contemplated that the appended claims will cover any modifications or embodiments as fall within the true scope of the invention.

## Claims

1. A semiconductor device comprising:
a semiconductor substrate;
a single crystal silicon island of one conductivity type formed on a main surface of said semiconductor substrate by being dielectrically isolated by a dielectric film;

a first diffusion region and a second diffusion region of the opposite conductivity type formed within said single crystal silicon island;

a third diffusion region of the one conductivity type formed in a portion within said single crystal silicon island excluding the gap portion between said first diffusion region and said second diffusion region;

a first electrode, a second electrode and a third electrode formed respectively by first level wiring layers, connected to a predetermined region within said first diffusion region, said second diffusion region and said third diffusion region, respectively;

a channel stopper electrode formed by a second level wiring layer between said first electrode and said second electrode; and

means for connecting said channel stopper electrode and said third electrode.

2. The semiconductor device as claimed in claim 1, wherein the end caps of said channel stopper electrode extend even to the outside of said single crystal silicon island.

3. The semiconductor device as claimed in claim 1, wherein a part of said first electrode and a part of said second electrode are covered by said channel stopper electrode.

4. The semiconductor device as claimed in claim 1, wherein said dielectric film is a silicon dioxide film formed by thermal oxidation.

5. The semiconductor device as claimed in claim 1, wherein the package for said semiconductor device is a resin sealed package.

6. The semiconductor device as claimed in claim 1, wherein said predetermined region within said first diffusion reigon is a fourth diffusion region of the one conductivity type formed within said first region.

7. The semiconductor device as claimed in claim 6, wherein the end caps of said channel stopper electrode extend even to the outside of said single crystal silicon island.

8. The semiconductor device as claimed in claim 6, wherein a part of said first electrode and a part of said second electrode are covered by said channel stopper electrode.

9. The semiconductor device as claimed in claim 6, wherein said dielectric film is a silicon dioxide film formed by thermal oxidation.

10. The semiconductor device as claimed in claim 6, wherein the package of said semiconductor device is a resin sealed package.

FIG.1A

FIG.1B

FIG.2

FIG.3A

FIG.3B

FIG.3C

FIG.3D

FIG.3E

FIG.3F

FIG.3G

105a

FIG.3H

101c    103a    101c    101c

105b

FIG.3I

109  110  106  107  111  112  108

FIG.4

$$I_C = 10\mu A$$
$$\overline{V}_{CE} = -260\overline{V}$$
$$\overline{W}_B = 55\mu m$$

FIG.5

$\overline{V}_{ext}$ ($\overline{V}$)

**FIG.6**

$V_{CE}$

$I_B$

$I_C$ (A)

$\bar{V}_{ext}$

117  112  116

118  106  110  115  107  111  108

**FIG.7**

$I_C = 10\mu A$

$\bar{V}_{CE} = -260\bar{V}$

$W_B = 55\mu m$

$h_{FE}$

400

300

200

100

0

100   50   0   50   100   150

$\bar{V}_{ext}(\bar{V})$

FIG.8A

334　337　315a　315　335　336

303

305,
309,
313

A　　　　　　　　　　　A'

315b　　314

FIG.8B

334　337　315　335　336　313

309
303
301
305

330　333　331　332

European Patent
Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | GB-A-1159937 (IBM) <br> * page 1, column 2, line 80 - page 2, column 1, line 6; figure 3 * <br> --- | 1 | H01L29/73 <br> H01L29/743 <br> H01L29/06 |
| Y | US-A-3858235 (SIEMENS) <br> * column 1, lines 8 - 20; claim 1; figures 3, 5 * <br> --- | 1, 6 | |
| Y | PATENT ABSTRACTS OF JAPAN <br> vol. 11, no. 117 (E-498)(2564) 11 April 1987, <br> & JP-A-61 263270 (NEC CORPORATION) 21 November 1986, <br> * the whole document * <br> --- | 1, 6 | |
| A | US-A-4321616 (OKI ELECTRIC INDUSTRY) <br> * column 1, lines 37 - 47; figures 2, 3 * <br> ----- | 1, 5, 10 | |
| | | | TECHNICAL FIELDS SEARCHED (Int. Cl.5 ) <br><br> H01L |

The present search report has been drawn up for all claims

| Place of search | Date of completion of the search | Examiner |
|---|---|---|
| THE HAGUE | 20 SEPTEMBER 1990 | NILES N.P.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)